# EUROPEAN PATENT APPLICATION

(11) **EP 2 413 351 A1**
(43) Date of publication of application: **01.02.2012**
(21) Application number: 09842303.1
(22) Date of filing: 01.09.2009
(51) Int. Cl.: H01L 21/60

(54) **COATED COPPER WIRE FOR BALL BONDING**

(30) Priority: 23.03.2009 JP 2009069462
(71) Applicant: Tanaka Denshi Kogyo K.K., Tokyo 100-6422 (JP)
(72) Inventor: YAMASHITA Tsutomu, Kanzaki-gun Saga 842-0031 (JP); AKIMOTO Hideyuki, Kanzaki-gun Saga 842-0031 (JP); KUWAHARA Takeshi, Kanzaki-gun Saga 842-0031 (JP); OKAZAKI Junichi, Kanzaki-gun Saga 842-0031 (JP)
(74) Representative: Peaucelle, Chantal
(86) International application number: PCT/JP2009/065227
(87) International publication number: WO 2010/109693

(57) **Abstract**

To provide a covered Cu wire for ball bonding which can be avoid inconvenience oxidation of core material of Cu and/or Cu alloy on ball forming after pulling and cutting away.

A covered Cu wire comprising: core material of Cu-P alloy, and intermediate layer of Pd or Pt on the core material and surface layer of Au on the intermediate layer.

## Description

### FIELD OF THE INVENTION

The present invention relates to a covered Cu wire, connecting by ball bonding with electrodes on semiconductor devices and lead parts of electric circuit substrates.

### STATE OF THE ART

Currently, an around 20 - 50 µ meters diameter Au wire as a bonding wire is mainly used by ball bonding with electrodes on semiconductor devices and outer leads. For this Au bonding wire, thermo-sonic-compression method is generally used, and it is used a multi-purpose bonding equipment and a capillary jig threading the wire through its inside. At the first bonding, heating and moltening a tip of wire with arc heating, forming a ball with surface tension, then this ball part is compressed and bonded to an electrode heated up the range of 150 - 300 degrees Celsius on a semiconductor device. Following this step, after forming a loop shape of wire by a capillary jig, at the second bonding, the wire is directly bonded by thermo-sonic-compression to an outer lead side, and then the wire is cut away.

Recent years, such structures, materials and bonding technologies of semiconductors packaging are diversified rapidly, for instance, as an implementation structure, new modes such as Quad Flat Packaging: QFP using current lead flames, and Ball Grid Array: BGA using substrates and polyimide tape and Chip Scale Packaging: CSP have been in practical use, it is required bonding wire improved loop characteristics, bondability and mass producibility.

Objective partner materials of bonding wire are also diversified, on electric circuit of Silicon substrates, and on electrode materials, Cu has been used in practical use as suitable for finer circuits, adding current Al alloys. Moreover, many cases are treated such Ag plated and Pd plated on lead-frames, and membrane of precious metals such as Au and/or its alloys on Cu circuit on resin substrate and/or tape. It is required to improve bondability of wire and liability of bonding corresponding to these objective partner materials of bonding.

Instead of using Au wire of high purity of the 4N series (the purity is more than 99.99 wt %.), initially it is considered using Cu wire of the 3N - the 6N series. (The purity is more than 99.9 - 99.9999 wt %.) However, in the case of Cu wire, there is a flaw that is easy to oxidize. On the requirements from bonding technologies, it is important to form a ball with good sphereness at ball forming and to acquire sufficient bonding strength at bonding area with a ball and an electrode, but forming a moltening ball at the first bonding, since moltening Cu oxidizes catching oxygen in the Air and the ball becomes hard, there is a fatal flaw to break semiconductor chips. Therefore, high purity of the 3N - 6N series of Cu wire should use in the deoxdizational atmosphere, it is so limited to use Cu wire for ball bonding of semiconductor devices.

On the other hand, it was invented that 0.002 - 0.5 µ meters cover layer of Pd, Pd-Ni, and Pd-Co around core material of Cu and Cu-Sn alloy in order to improve anti-corrosion and strength. (Cf. Reference Patent 1) And as the method to avoid surface oxidation of Cu bonding wire, it was proposed Cu bonding wire covered by precious metals such as Au, Ag, Pt, Pd, Ni, Co, Cr, and Ti and anti-corrosion metals. (Cf. Reference Patent 2 - 4.)

### THE PRECEDING TECHNICAL LITERATURE

[Reference Patent 1] Published utility model application S60-160554
[Reference Patent 2] Published patent application S62-97360
[Reference Patent 3] Published patent application 2005-167020
[Reference Patent 4] Japanese Patent 4203459

### DISCLOSURE OF INVENTION

### ISSUES TO BE SOLVED BY THE PRESENT INVENTION

However, though in the case of covered Cu wire, cutting the covered Cu wire at the second bonding, core material of Cu and/or Cu alloy exposes at tip of cut surface, the exposed surface is oxidized. Therefore, as soon as forming a ball at the first bonding, though core Cu wire coated by precious metals does not be oxidized, oxidized membrane of exposed surface of Cu remains as a trace at the bottom of a ball melted and clotted, the ball part where to be bonded to a semiconductor chip becomes hard, then it becomes a problem that semiconductor chip may have a damage at the first bonding.

Considering the above mentioned circumstances, the present invention aims to provide a covered Cu wire for ball bonding in order to avoid such inconvenience of oxidation of core Cu and core Cu alloy at ball bonding after cutting and finishing a ball among covered Cu wires for ball bonding.

### ISSUES TO BE SOLVED BY THE PRESENT INVENTION

The present invention in order to be solved the above mentioned issues comprises following keystones.
(1) A covered Cu wire for ball bonding comprising: core material of Cu as a main component and 2 kinds of covered layers on the said core material, and wherein the said core material is Cu - 1- 500 wt ppm of P alloy and the said covered layers comprise an intermediate layer of Pd or Pt and a surface layer of Au.
(2) A covered Cu wire for ball bonding comprising: core material of Cu as a main component and 2 kinds of covered layers on the said core material, and wherein the said core material is Cu - 1- 80 wt ppm of P alloy and the said covered layers comprise an intermediate layer of Pd or Pt and a surface layer of Au.
(3) A covered Cu wire for ball bonding comprising: core material of Cu as a main component and 2 kinds of covered layers on the said core material, and wherein the said core material is Cu - 200- 400 wt ppm of P alloy and the said covered layers comprise an intermediate layer of Pd or Pt and a surface layer of Au.
(4) A covered Cu wire for ball bonding comprising: component of core material except P is more than 99.999 wt % of Cu, and wherein the above mentioned (1) - (3).
(5) A covered Cu wire for ball bonding comprising: component of core material except P is more than 99.9999 wt % of Cu, and wherein the above mentioned (1) - (3).
(6) A covered Cu wire for ball bonding comprising: thickness of the intermediate layer is 0.005 - 0.2 µ meters, and wherein the above mentioned (1) - (3).
(7) A covered Cu wire for ball bonding comprising: thickness of the intermediate layer is 0.01 - 0.1 µ meters, and wherein the above mentioned (1) - (3).
(8) A covered Cu wire for ball bonding comprising: thickness of the surface layer is 0.005 - 0.1 µ meters, and wherein the above mentioned (1) - (3).
(9) A covered Cu wire for ball bonding comprising: thickness of the surface layer is thinner than thickness of the intermediate layer, and wherein the above mentioned (1) - (3).

### EFFECTS OF THE PRESENT INVENTION

According to the present invention, it is possible to avoid the effect of core material of Cu oxidation at forming a moltening ball of the first bonding, because lower melting point of surface layer element of Au melts earlier than intermediate layer element, surface layer element spread to exposed oxidized part of core material of Cu, moreover oxidized part of core material is separated and dissolved by concentration of P at surface layer and by deoxidation effect of P which includes in the core material of Cu alloy.

One of the covered Cu wires of the present invention comprises Cu - 1 - 500 wt ppm of P alloy as a core material. The reason of adding 1 - 500 wt ppm of P, is the sake to resolve and remove oxidized membrane of Cu formed at exposed portion of core material by the effect of deoxidation. P on the surface of moltening ball sublimates by oxidation. At this moment, since P has a function of forming a concentrated layer near at a surface of core material, it is possible to inhibit and delay to generate oxidized Cu formed at a surface of core material and it is possible to maintain the thickness of oxidized membrane at the lowest level with an effect of the surface layer of Au mentioned herein after.

One of the covered Cu wires of the present invention comprises Cu - 1 - 80 wt ppm of P alloy as a core material. Though P is a kind of trace, P has an effect to rise re-crystallization temperature and strengthen the strength of wire itself. The higher purity of Cu is the lesser effect of impurity against P, so it is available to the lesser additive of P.

One of the covered Cu wires of the present invention comprises Cu - 200 - 400 wt ppm of P alloy as a core material. If there were several ten wt ppm of impurity elements except P, such amount of P has an inhibitory and delaying effect of generation of oxidized Cu formed at core material surface.

However, it is preferable that impurity elements except P do not include in the Cu-P alloy of core material. Because, these impurity elements form oxide reacting with oxygen in the Air, then a moltening ball becomes hard at the first bonding. Conversely, the lesser impurity elements, if increasing amount of P to several hundreds wt ppm, a moltening ball tends to become not hard. Concretely, it is preferable that component except P of core material is more than purity of 99.999 wt % of Cu, and it is more preferable more than purity of 99.9999 wt % of Cu. By the way, "purity of 99.999 wt %" means that impurity elements except P and Cu are less than 0.001 wt % without gaseous elements such as O, N and C existing in Cu.

The intermediate layer among 2 kinds of covered layers comprises Pt or Pd and/or Pd-Pt alloy. Melting point of Pd (1554 degrees Celsius) and Pt (1770 degrees Celsius) which ever is higher than melting point of Cu (around 1085 degrees Celsius). Therefore, at the initial stage of forming a moltening ball as ball shape from core material of Cu, Pd and/or Pt and/or Pd-Pt alloy becomes a membrane, then it prevent and delay forming oxidation from a side of moltening ball.

It is preferable that thickness of the intermediate layer is 0.005 - 0.2 µ meters, and it is more preferable that it is 0.01 - 0.1 µ meters. In the case of less than 0.005 µ meters, there is a tendency of insufficient effect of delay of oxidation as a membrane. In the case of more than 0.2 µ meters, there is a tendency of occurrence of breaking chips by alloying of Cu-ball decreasing purity of Cu.

However, since a membrane of Pd or Pt, or a membrane of Pd-Pt alloy is absorbed into a moltening ball, this membrane does not cover whole exposed part of core material, or an oxidized layer of tip of a Cu-ball formed by electric arc discharge. Moreover, the melting point of the outer surface rise up, since arc discharge requires larger energy, then oxidation of tip surface of wire is promoted. So, at the stage of forming a moltening ball from core material of Cu, means to prevent oxidation of exposed part of core material are required. Therefore, in the present invention, we add P into core-material; moreover we use Au as a surface layer among 2 kinds of covered layers. Since, melting point of Au (around 1064 degrees Celsius) is lower than melting point of Cu (around 1085 degrees Celsius), at the forming stage of ball shape moltening ball of Cu, lower melting point of Au at surface layer melts earlier than Cu and wraps rapidly tip surface of wire, then it promotes to melt Cu. Next moment, after melting Cu, a membrane of Pd and/or Pt of intermediate layer becomes soften, then a moltening ball is formed. Thus, it is considered that during the process of forming a moltening Cu ball, the surface layer of lower melting point of Au promotes to melt Cu, is absorbing membrane of Pd or Pt into a moltening ball earlier, is covering a tip of moltening Cu-ball, then it is enable to prevent oxidation of Cu.

Thickness of surface layer among 2 kinds of covered layer is preferable to be thinner than thickness of intermediate layer. The thicker surface layer needs the longer time to melt, promoting effect of melting Cu will decrease, a moltening ball becomes hard itself by alloying and surface segregation of moltening ball, break of semiconductor chip is apt to occur. It is enough that as thickness of surface layer, if there is a sufficient thickness of absorbing membrane of such Pd or Pt into a moltening ball immediately; preventing oxidation of Cu formed exposed part of moltening ball core material. Concretely, as thickness of Au surface layer, 0.005 - 0.2 µ meters is preferable, 0.005 - 0.02 µ meters is more preferable, and the best is 0.005 - 0.01 µ meters.

Pd or Pt of intermediate layer and Au of surface layer are elements which do not oxidize during formation of a moltening ball. And since these elements do not react with S in the Air like Ag, these elements do not affect wrong effect to core material of Cu. Moreover, element of Pd or Pt do not affect wrong effect to P included in the core material of Cu. And Au of surface layer has complete solubility to core material of Cu. Consequently, the deoxidation effect of P against a Cu-ball in the solidification process of a Cu-ball from moltening state at the first bonding is equivalent to semiconductor chip regardless existence of covered layers. And, as an intermediate layer and a surface layer as 2 kinds of covered layers are formed by precious metals, there is an effect that bonding strength becomes higher than Cu of core material is bonded directly to a lead-frame, because of prevention of oxidation of Cu by covered layer.

Plating method is good to form Pd or Pt of intermediate layer and Au surface layer on the surface of core material of Cu. Electrolytic plating, electroless plating and fused salt plating are possible among plating methods. As electrolytic plating to obtain a thin plating thickness so called strike plating or flash plating has fast plating speed, and has good adhesion to substrate, it is preferable in the case of electrolytic plating. Solutions for electroless plating is classified into substitution type and reduction type, in the case of thin membrane like Au surface layer, it is enough only substitution type, but in the case of forming somewhat thicker membrane like Pd or Pt intermediate layer, it is efficient to plate substitution type of own catalyst type after substitution type plating. Equipments for electroless plating method are simple, and it is easy to plate, but it needs more time to plate than electrolytic plating. In the plating bath, it is preferable to include phosphoric acid or phosphoric acid salt. Because, in the process of precipitation of Au, Pd and Pt involving P, so there is a better effect of deoxidation of P at the surface of ball of moltening Cu, when core material of Cu melts at the first bonding. Concretely, because, there is an effect of dissolving and removing oxidized membrane of Cu formed exposed part of core material, moreover, there is an effect of delaying oxidation of moltening Cu.

On the other hand, among methods of physical vapor deposition, it can be used physical adhesion such as sputtering, ion plating, and physical vapor deposition and chemical adhesion such as plasma CVD. All these are dry processes. Cleaning after forming membrane is not required and there is no anxiety of surface contamination of cleaning, if neglecting cost.

After making plated membrane or vapor deposited membrane on a large diameter of core material, dice drawing to the aimed wire diameter for plural times is efficient at the stage of plating or vapor deposition. Because, crystal structure of plating or vapor deposition is conditioned to plastic work state by drawing. Preferable covering method is after forming electrloritic membrane of intermediate layer and surface layer immersing a large diameter wire in the electrolytic plating bath after strike plating. It is possible to obtain the final wire diameter to draw this covered Cu wire. Strike plating by Pd or Pt is preferable if necessary.

In the case to form plural layers comprising with more than 2 kinds of metals on the surface layer, it is inevitable to form plural different metallic membranes by such as plating method, vapor deposition method and/or fused method sequentially. In processing, the method of heat treatment after forming all different metals, the method of heat treatment after each forming one metal layer and stacking it step by step are efficient.

### DESCRIPTION OF THE MOST PREFERRED EMBODIMENT

Hereinafter, the most preferred embodiment is described.

Core material of Cu wire was drawn to 500 µ meters diameter from Cu ingot included prescribed amount of P. The surface of wire was electrolytic plating by conventional method after strike plating. Preparing 3 kinds of wire covered by Pd and/or Pt as an intermediate layer, Au was plated to these 3 kinds of wire as a surface layer. Plating bath solution was used in the commercial market for semiconductor use. Concretely, in the proportion of 10 g/l of phosphorous acid was added into neutral dinitro -diamine-Pd solution for Pd. For Pt, acid Pt-phosphorous acid was used. In the proportion of 100 g/l of phosphorous acid was added into neutral cyanate Au bath for Au. Then, drawing the covered wires to the final diameter of 25 µ meters, finally they were heat treated removing work strain and conditioned around 10 % elongation value. The final thickness of plating is shown in Table 1. By the way, thickness of plating was measured by Auger Electron Spectroscopy: AES.

**Table 1 Structure of each covered Cu wire**

| | | Surface Layer | Intermediate Layer 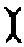 is formed on ahead | | | Core material | |
|---|---|---|---|---|---|---|---|
| | | Au surface layer (µm) | Pd intermediate layer (µm) | Pt intermediate layer (µm) | Au intermediate layer (µm) | Purity of Cu (%) | Content of P (wt ppm) |
| | 1 | 0.007 | 0.02 | Nothing | Nothing | 99.9999 | 10 |
| | 2 | 0.08 | Nothing | 0.05 | Nothing | 99.9999 | 30 |
| | 3 | 0.04 | 0.05 | Nothing | Nothing | 99.9999 | 20 |
| | 4 | 0.008 | Nothing | 0.01 | Nothing | 99.9999 | 40 |
| | 5 | 0.06 | Nothing | 0.12 | Nothing | 99.9999 | 70 |
| | 6 | 0.02 | 0.08 | Nothing | Nothing | 99.9999 | 100 |
| | 7 | 0.006 | Nothing | 0.06 | Nothing | 99.9999 | 200 |
| | 8 | 0.015 | 0.15 | Nothing | Nothing | 99.9999 | 400 |
| | 9 | 0.09 | Nothing | 0.05 | Nothing | 99.9999 | 75 |
| | 10 | 0.009 | 0.007 | Nothing | Nothing | 99.9999 | 350 |
| Examples | 11 | 0.12 | Nothing | 0.22 | Nothing | 99.9999 | 25 |
| | 12 | 0.13 | 0.24 | Nothing | Nothing | 99.9999 | 450 |
| | 13 | 0.15 | (0.15) | 0.15 | Nothing | 99.9999 | 65 |
| | 14 | 0.011 | Nothing | 0.04 | Nothing | 99.999 | 90 |
| | 15 | 0.07 | 0.14 | Nothing | Nothing | 99.999 | 280 |
| | 16 | 0.008 | Nothing | 0.013 | Nothing | 99.999 | 120 |
| | 17 | 0.03 | Nothing | 0.06 | Nothing | 99.999 | 250 |
| | 18 | 0.095 | 0.16 | Nothing | Nothing | 99.999 | 210 |
| | 19 | 0.006 | 0.02 | (0.01) | Nothing | 99.999 | 160 |
| | 20 | 0.05 | (0.10) | 0.07 | Nothing | 99.999 | 180 |
| | 21 | 0.055 | 0.23 | Nothing | Nothing | 99.999 | 2 |
| | 22 | 0.14 | Nothing | 0.13 | Nothing | 99.999 | 480 |
| | 23 | Nothing | 0.05 | Nothing | Nothing | 99.999 | Nothing |
| | 24 | Nothing | 0.3 | Nothing | Nothing | 99.999 | Nothing |
| | 25 | Nothing | Nothing | 0.01 | Nothing | 99.9999 | Nothing |
| Controls | 26 | Nothing | Nothing | 0.1 | Nothing | 99.9999 | Nothing |
| | 27 | 0.8 | | Nothing | Nothing | 99.999 | Nothing |
| | 28 | Nothing | 0.8 | Nothing | (0.01) | 99.999 | Nothing |
| | 29 | Nothing | Nothing | 0.1 | 0.005 | 99.999 | Nothing |
| | 30 | Nothing | Nothing | Nothing | Nothing | 99.9999 | Nothing |

Ball/stitch bonding was done using the wire bonder (UTC-1000 type: Brand name) from Shinkawa Co. Ltd., for connecting boding wire. Forming a ball at tip by arc discharge in the Nitrogen atmosphere, it was bonded to 0.8 µ meters Aluminum electrode membrane (Al-0.5 % Cu) on a Silicon substrate, and wedge/stitch bonding of the other terminal was done to a 4 µ meters Ag plated lead on a lead-frame at 200 degrees Celsius heated at 2 kW, frequency 1/200 cycles.

By the way, conditions of the first bonding were as follows.
Temperature of bonding: 200 degree centigrade.
Initial ball diameter: 40 - 60 µ meters.
Results of test are shown in Table 2.

In observation of the initial ball shape, observing 20 balls before bonding, they were judged whether shpereness in shape is good or not, whether dimension accuracy is good or not. If there are more than 2 abnormal shape balls, it is shown as "Bad", if there are less than 2 abnormal shape balls moreover there are more than 5 outstanding positioning off-set (misalignment) balls to the wire, it is shown as "Fair", if there are 2 - 4 positioning off-set balls, it is shown as "Good" from the aspect of practical use. In the case of that there is less than one positioning off-set and dimensional accuracy is good, since ball forming is good, so it shown as "OK".

In judging bonding shape of compressed bonded ball, through observing 500 bonded balls, roundness of the shape and dimensional accuracy was evaluated. Diameters of compressed bonded ball were selected from the condition of the range of 2 - 3 times of wire diameter. If there are more than 5 defective balls such as large anisotropical off-set from a true circle or ellipse shape, it is shown as "Bad". If there are 2 - 4 defective balls and there are more than 8 profiles of petal shape at compressed ball, since it is required improvement, it is shown as "Fair". If there is less than one defective ball, and 3 - 7 defective deformations, judging there is no problem in practical use, it is shown as "Good". If there are less than 2 deformations of petal shape, judging good, it is shown as "OK".

On the oxidation of moltening ball, it was confirmed that chip break does not occur at ball bonding for 50 chips. In the case of that breaks generated on a Silicon chip exposed on Aluminum pad by alkaline etching, it is shown as numerical digits of them.

On evaluation of stitch bonding, on bonding loop super sonic compressed bonded to Ag plated lead-frame, the break load was measured by pulling vertically using a pull hook at 20 % position from stitch side in length. Mean value of 50 loops in the unit of mN is shown.

In Table 2 evaluation results on the present invention are shown.

**Table 2 Evaluation results of covered wires**

| | | Sphereness | Roundness | Damage of chip | Pull of stitch | Total Evaluation |
|---|---|---|---|---|---|---|
| | 1 | OK | Good | OK | 89 | OK |
| | 2 | OK | OK | Good | 93 | OK |
| | 3 | Good | OK | Good | 90 | OK |
| | 4 | OK | OK | OK | 101 | OK |
| | 5 | Good | Good | Fair | 88 | Good |
| | 6 | OK | OK | Good | 94 | OK |
| | 7 | OK | OK | Good | 99 | OK |
| | 8 | Good | OK | Fair | 81 | Good |
| | 9 | Fair | Good | Good | 95 | OK |
| | 10 | Good | OK | Good | 91 | OK |
| Examples | 11 | Fair | Fair | Good | 76 | Fair |
| | 12 | Fair | Fair | Bad | 63 | Fair |
| | 13 | Fair | Good | Bad | 72 | Fair |
| | 14 | OK | Good | Good | 86 | OK |
| | 15 | Good | Good | Fair | 94 | Good |
| | 16 | OK | OK | Good | 90 | OK |
| | 17 | Good | OK | OK | 91 | OK |
| | 18 | Fair | Good | Fair | 89 | Good |
| | 19 | OK | Good | Good | 93 | OK |
| | 20 | Good | Good | Fair | 92 | Good |
| | 21 | Good | Good | Fair | 72 | Good |
| | 22 | Fair | Good | Fair | 77 | Good |
| | 23 | Fair | Bad | Bad | 87 | Bad |
| | 24 | Bad | Good | Bad | 88 | Bad |
| | 25 | Fair | Bad | Fair | 90 | Bad |
| Controls | 26 | Good | Bad | Fair | 93 | Bad |
| | 27 | Bad | Bad | Good | 74 | Bad |
| | 28 | Fair | Fair | Bad | 85 | Bad |
| | 29 | Fair | Fair | Bad | 93 | Bad |
| | 30 | Good | Bad | Fair | 54 | Bad |

Example 1, 3, 6, 8, 10, 12, 15, 18 and 21 are the first group of (AU/Pd/CuP) covered bonding wire. Examples 2, 4, 5, 7, 9, 11, 14, 16, 17 and 22 are the second group of (Au/Pt/CuP) covered bonding wire. Examples 11 - 19 and 20 are the third group of (Au/(Pt-Pd)/CuP) covered bonding wire. Example 13 among the third group was heat treated at the condition of 900 degrees Celsius for 20 seconds. Control 23 - 30 in Table 1 are out of claims of the present invention. The evaluation results are shown.

It is confirmed that bonding wire of Example 1 - 4, 6, 7,10, 14, 16, 17 and 19 are superior at sphereness and roundness of ball part, and are good at stitch bondability and shape of compressed state, moreover are no damage of chip. In the case of Control 23 - 30, which are out of application of the present invention, or just simple Cu wire formed metallic membrane except Cu on surface, these characteristics are unsatisfactory. Though Example 5 - 10 bonding wires among Example 5, 15, 18, and 20 - 22 are inferior than above mentioned Example 1 - 5 bonding wires, it is confirmed that sphereness and roundness of ball part is superior and are lesser at chip damages and are good at stitch bondability and compressed bonding shape.

It is confirmed on Example 11 - 13 bonding wires that they are somewhat inferior than above mentioned bonding wire, as same as Example 1 - 5, they are superior at sphereness and roundness of ball part, are lesser at chip damages, are not defaults like Controls, are good at wedge bondability and compressed bonding shape. By the way, Example 13 was same results as Example 11 and 12.

## Claims

1. A covered Cu wire for ball bonding comprising: core material of Cu as a main component and 2 kinds of covered layers on the said core material, and wherein the said core material is Cu - 1- 500 wt ppm of P alloy and the said covered layers comprise an intermediate layer of Pd or Pt and a surface layer of Au.

2. A covered Cu wire for ball bonding comprising: core material of Cu as a main component and 2 kinds of covered layers on the said core material, and wherein the said core material is Cu - 1- 80 wt ppm of P alloy and the said covered layers comprise an intermediate layer of Pd or Pt and a surface layer of Au.

3. A covered Cu wire for ball bonding comprising: core material of Cu as a main component and 2 kinds of covered layers on the said core material, and wherein the said core material is Cu - 200- 400 wt ppm of P alloy and the said covered layers comprise an intermediate layer of Pd or Pt and a surface layer of Au.

4. A covered Cu wire for ball bonding comprising: component of core material except P is more than 99.999 wt % of Cu, and wherein according to the above mentioned Claim 1 - Claim 3.

5. A covered Cu wire for ball bonding comprising: component of core material except P is more than 99.9999 wt % of Cu, and wherein according to the above mentioned Claim 1 - Claim 3.

6. A covered Cu wire for ball bonding comprising: thickness of the intermediate layer is 0.005 - 0.2 µ meters, and wherein according to the above mentioned Claim 1 - Claim 3.

7. A covered Cu wire for ball bonding comprising: thickness of the intermediate layer is 0.01 - 0.1 µ meters, and wherein according to the above mentioned Claim 1 - Claim 3.

8. A covered Cu wire for ball bonding comprising: thickness of the surface layer is 0.005 - 0.1 µ meters, and wherein according to the above mentioned Claim 1 - Claim 3.

9. A covered Cu wire for ball bonding comprising: thickness of the surface layer is thinner than thickness of the intermediate layer, and wherein according to the above mentioned Claim 1 - Claim 3.
